# FASCICULE DE BREVET EUROPEEN

(11) **EP 3 478 044 B1**
(45) Date de publication et mention de la délivrance du brevet: **13.05.2020**
(21) Numéro de dépôt: 18203015.5
(22) Date de dépôt: 29.10.2018
(51) Int. Cl.: H05K 7/14

(54) **ENSEMBLE COMPORTANT UNE STRUCTURE PORTEUSE COMPORTANT DES ÉLÉMENTS STRUCTURAUX VERTICAUX, ET UN MODULE COMPORTANT DES ÉQUIPEMENTS ÉLECTRONIQUES FIXÉ SUR LA FACE AVANT DES ÉLÉMENTS STRUCTURAUX VERTICAUX**
ANORDNUNG, DIE EINE TRAGSTRUKTUR MIT VERTIKALEN STRUKTURELEMENTEN UMFASST, UND EIN MODUL, DAS ELEKTRONISCHE AUSRÜSTUNGEN UMFASST UND AUF DER VORDERSEITE DIESER VERTIKALEN STRUKTURELEMENTE BEFESTIGT IST
ASSEMBLY COMPRISING A SUPPORTING STRUCTURE WITH VERTICAL STRUCTURAL ELEMENTS, AND A MODULE HAVING ELECTRONIC EQUIPMENT ATTACHED TO THE FRONT FACE OF THE VERTICAL STRUCTURAL ELEMENTS

(30) Priorité: 31.10.2017 FR 1760299
(43) Date de publication de la demande: 01.05.2019
(73) Titulaire: Airbus Operations S.A.S., 31060 Toulouse (FR)
(72) Inventeur: GUERING, Bernard, 31850 MONTRABE (FR); DELAHAYE, Romain, 31770 COLOMIERS (FR)
(74) Mandataire: Gicquel, Olivier Yves Gérard

(56) Documents cités:
- FR-A1- 2 958 829
- US-B1- 8 550 260

## Description

La présente invention concerne un ensemble comportant un module comportant des équipements électroniques, et une structure porteuse associée.

L'invention trouve notamment son application, de manière non limitative, dans l'intégration de modules avioniques sur les aéronefs.

Dans un aéronef, des équipements électroniques sont regroupés en boîtiers ou modules électroniques et disposés sur une structure porteuse telle qu'un meuble.

En général, ces structures porteuses ou meubles, accueillant les modules électroniques, sont situées dans la partie basse de l'aéronef, entre le cockpit et les ailes.

Dans le domaine avionique, ces boîtiers électroniques, aussi connus comme calculateurs, sont souvent conformes à la norme ARINC 600 ou sont de type IMA pour « *Integrated Modular Avionic* » et sont disposés sur des meubles dédiés à les recevoir suivant des normes spécifiques.

Un meuble dédié logeant des boîtiers est connu du document FR 3 000 030.

Ces meubles dédiés à accueillir les équipements électroniques sont volumineux.

La présente invention a pour but d'optimiser le volume occupé par l'ensemble formé par des modules comportant des équipements électroniques, et la structure porteuse sur laquelle les modules sont disposés, en proposant un ensemble moins volumineux comportant un module comportant des équipements électroniques, et une structure porteuse associée.

A cet effet, la présente invention concerne selon un premier aspect un ensemble comportant un module comportant des équipements électroniques, et une structure porteuse associée.

La structure porteuse comporte au moins deux éléments structuraux verticaux ayant une face avant et une face arrière, le module comportant des moyens de fixation conçus pour la fixation dudit module sur la face avant desdits au moins deux éléments structuraux verticaux.

Selon l'invention, ladite structure porteuse comporte au moins une plaque comportant une interface électrique conçue pour recevoir une interface électrique dudit module et les moyens de fixation sont logés par des moyens de réception traversant le module entre sa face avant et sa face arrière.

Ainsi, le module étant fixé sur la face avant des éléments structuraux verticaux, les éléments structuraux verticaux se trouvent situés derrière le module, et n'enveloppent pas le module sur ses faces latérales. Par conséquent, la structure porteuse est plus compacte et occupe un volume moins important que les meubles utilisés dans l'art antérieur.

En outre, le module étant fixé sur les éléments structuraux verticaux, des étagères les supportant ne sont pas nécessaires dans la structure porteuse, ce qui rend la structure porteuse plus légère.

Selon d'autres caractéristiques possibles, prises isolément ou en combinaison l'une avec l'autre :
- les moyens de réception recevant les moyens de fixation sont formés par une cavité s'étendant longitudinalement entre la face avant et la face arrière.
- les moyens de fixation traversent le module entre une face avant et une face arrière du module, et sont conçus pour être fixés sur la face avant des éléments structuraux verticaux;
   - - la structure porteuse comporte au moins une plaque comportant une interface électrique, ladite au moins une plaque étant placée entre lesdits au moins deux éléments structuraux verticaux au niveau de la face avant des éléments structuraux verticaux, l'interface électrique dans ladite au moins une plaque étant conçue pour recevoir une interface électrique dudit module, et comportant des liaisons électriques pour relier ladite interface électrique de la structure porteuse à un système de câblage électrique ;
- l'ensemble comporte un système de ventilation comportant des conduits de soufflage d'air et des conduits d'extraction d'air, un élément structural vertical comportant un conduit de soufflage d'air et un conduit d'extraction d'air ;
- le module comporte un conduit de soufflage d'air et un conduit d'extraction d'air dudit système de ventilation ;
- l'élément structural vertical comporte une entrée d'air et une sortie d'air, ledit conduit d'extraction d'air d'un module étant relié à ladite sortie d'air d'un premier élément structural vertical et ledit conduit de soufflage d'air dudit module étant relié à ladite entrée d'air d'un second élément structural vertical ;
- le module comporte en outre un caisson situé sous lesdits équipements électroniques, les conduits de soufflage et d'extraction étant situés à l'intérieur dudit caisson ;
- les moyens de fixation traversent le caisson entre lesdites faces avant et arrière dudit module ;
- le module comporte des éléments de renfort situés le long des faces latérales du module ;
- les éléments de renfort sont deux éléments longitudinaux disposés entre la face avant et la face arrière du module, sur un plan s'étendant sur les faces latérales du module ;
- la structure porteuse comporte au moins deux éléments d'aide au montage dudit module, chaque élément d'aide au montage étant fixé sur la face avant de chaque élément structural vertical.

La présente invention concerne selon un deuxième aspect, un aéronef comportant un ensemble conforme à l'invention.

L'aéronef présente des caractéristiques et avantages analogues à ceux décrits précédemment en relation avec l'ensemble.

D'autres particularités et avantages de l'invention apparaîtront encore dans la description ci-après.

Aux dessins annexés, donnés à titre d'exemples non limitatifs :
- la figure 1 est une vue en perspective d'un ensemble conforme à un mode de réalisation de l'invention ;
- la figure 2A est une vue de face d'un ensemble selon un mode de réalisation de l'invention;
- la figure 2B est une vue latérale de l'ensemble représenté à la figure 2A ;
- la figure 2C est un schéma illustrant des moyens de fixation selon un mode de réalisation ; et
- la figure 3 est une vue de face de l'ensemble conforme à un mode de réalisation de l'invention dans lequel trois modules sont absents.

La présente invention trouve son application dans l'installation des équipements électroniques dans un aéronef, en particulier des boîtiers ou modules regroupant des équipements électroniques.

Plus particulièrement, l'invention trouve son application dans l'installation de modules de type IMA (« *Integrated Modular Avionic »).*

Bien entendu, l'invention peut s'appliquer dans l'installation de modules de type différent.

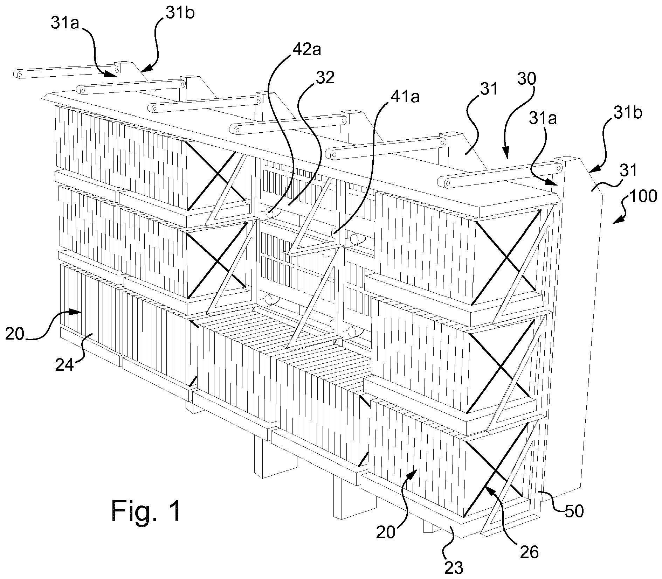

La **figure 1** représente une vue en perspective d'un ensemble 100 comportant des modules 20 comportant des équipements électroniques 24, et une structure porteuse 30 associée.

La structure porteuse 30 comporte au moins deux éléments structuraux verticaux 31.

Dans la structure porteuse 30 représentée à la figure 1, le nombre d'éléments structuraux verticaux 31 est de six.

La structure porteuse 30 accueille un ensemble de modules 20 comportant des équipements électroniques 24 (non représentés en détail dans la figure). Dans l'ensemble 100 représenté à la figure 1, onze modules 20 sont installés sur la structure porteuse 30. On notera que l'emplacement dédié à recevoir quatre autres modules 20 est représenté afin de montrer en détail la face avant de la structure porteuse 30.

Bien entendu, le nombre d'éléments structuraux verticaux 31 dans la structure porteuse 30 et le nombre de modules 20 accueillis par la structure porteuse 30 peuvent être différents.

Les éléments structuraux verticaux 31 présentent une forme de poutre ou de poteau et comportent une face avant 31a sur laquelle sont fixés les modules 20, et une face arrière 31b.

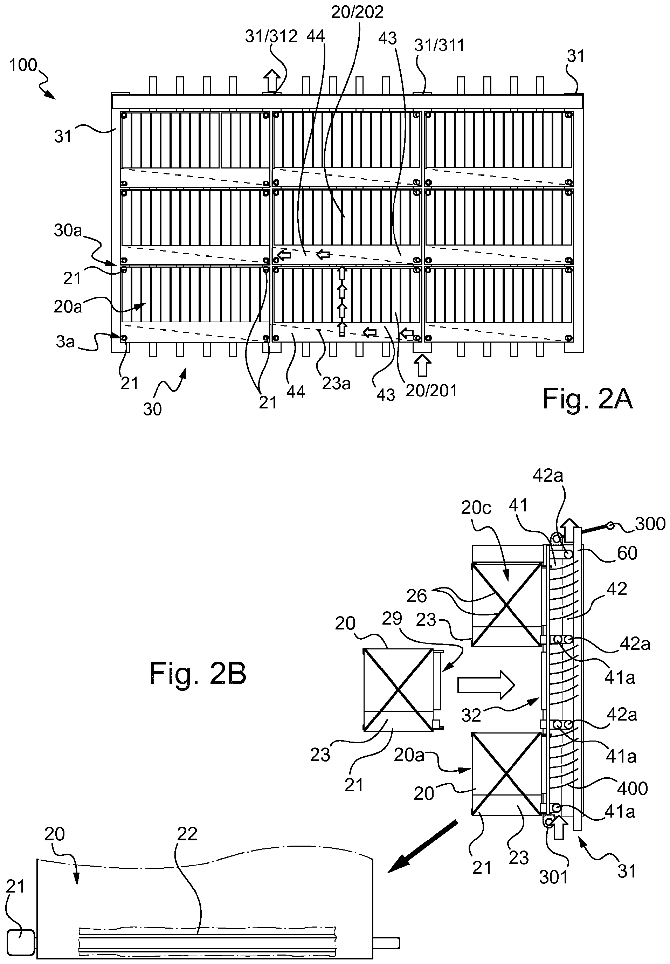

Au niveau de la face arrière 31b, sont positionnés une bielle 300 (visible sur la figure 2B) et une ferrure 301 pour maintenir la structure porteuse 30.

Dans un mode de réalisation, chaque élément structural vertical 31 est lié par une ferrure 301 située au niveau de sa partie inférieure, à une zone renforcée dédiée au maintien de la structure porteuse 30. Cette zone renforcée est disposée sur le fuselage de l'aéronef. La structure porteuse 30 est liée au niveau de sa partie supérieure par au moins une bielle 300 reliant un élément structural vertical 31 à une plate-forme horizontale située au-dessus de la structure porteuse 30 dans un plan perpendiculaire au plan dans lequel s'étendent les éléments structuraux verticaux 31. Cette plate-forme ou plancher peut correspondre au plancher ou sol de la cabine passagers de l'aéronef.

Bien entendu, le meuble peut être maintenu avec des moyens différents et/ou à des parties différentes de l'aéronef.

Les éléments structuraux verticaux 31 sont réalisés typiquement en alliage d'aluminium ayant une épaisseur comprise entre 2 et 4 mm.

A titre d'exemple nullement limitatif, la longueur des éléments structuraux verticaux 31 peut être comprise entre 500 mm et 2500 mm, et présente une valeur typique de 1200 mm. La dimension de la section transversale des éléments structuraux verticaux 31 peut typiquement présenter une valeur de 60 mm x 150 mm.

Le matériau et les dimensions des éléments structuraux verticaux 31 peuvent être différents et ne sont pas limités à ceux donnés ici.

Dans le mode de réalisation décrit, un module 20 est fixé à deux éléments structuraux verticaux 31.

Pour la fixation du module 20 sur la structure porteuse 30, le module 20 comporte des moyens de fixation conçus pour sa fixation sur la face avant 31a des éléments verticaux 31. Les moyens de fixation seront décrits ultérieurement en référence aux figures 2A et 2B.

La structure porteuse 30 comporte au moins une plaque 32 comportant une interface électrique conçue pour recevoir une interface électrique 29 du module 20 (visible sur la figure 2B). Chaque plaque 32 est placée entre deux éléments structuraux verticaux 31 au niveau de la face avant 31a des éléments structuraux verticaux 31.

L'interface électrique dans une plaque 32 de la structure porteuse 30 est reliée au moyen de liaisons électriques 400 (visible sur la figure 2B) à un système de câblage électrique 60 (visible sur la figure 2B), tel que le système de câblage électrique d'un aéronef.

Une fois que le module 20 est fixé aux éléments structuraux verticaux 31, l'interface électrique 29 du module 20 est reliée à l'interface électrique dans la plaque 32 de la structure porteuse 30. L'interface électrique dans la plaque 32 de la structure porteuse 30 est reliée à un système de câblage électrique 60, tel que le système de câblage électrique d'un aéronef. L'interface électrique 29 du module 20 est ainsi reliée au système de câblage électrique 60.

Dans le mode de réalisation représenté à la figure 1, trois plaques 32 comportant chacune une interface électrique sont disposées entre deux éléments structuraux verticaux 31 à des hauteurs différentes des éléments structuraux verticaux 31.

Bien entendu, le nombre de plaques 32 placées entre deux éléments structuraux verticaux 31 à des hauteurs différentes peut être différent.

Dans le mode de réalisation décrit, chaque module 20 est fixé à la structure porteuse 30 au niveau de chaque plaque 32. Ainsi, chaque plaque 32 de la structure porteuse 30 reçoit une interface électrique 29 d'un module 20. En particulier, l'interface électrique dans chaque plaque 32 reçoit une interface électrique 29 d'un module 20.

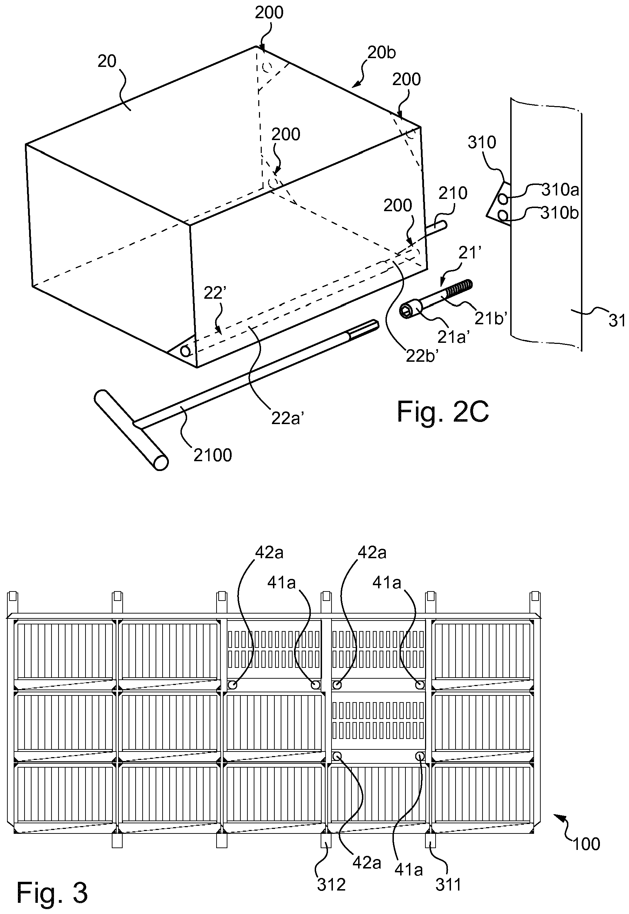

Les **figures 2A et 2B** représentent respectivement une vue de face d'un ensemble conforme à un mode de réalisation de l'invention et une vue de côté. Les moyens de fixation du module 20 à la structure porteuse 30 sont décrits ci-après en référence aux figures 2B et 2C.

On notera que la structure porteuse 30 représentée à la figure 2A comporte quatre éléments structuraux verticaux 31 et que trois modules 20 sont fixés à trois hauteurs différentes entre deux éléments structuraux verticaux 31 consécutifs.

Ainsi, neuf modules 20 sont fixés sur la structure porteuse 30 représentée sur la figure 2A.

Les modules 20 sont fixés sur la face avant 31a des éléments structuraux verticaux 31 par des moyens de fixation 21.

Dans un mode de réalisation (voir figures 2B et 2C), les moyens de fixation 21 sont logés par des moyens de réception 22 traversant le module 20 entre sa face avant 20a et sa face arrière 20b.

Dans un mode de réalisation, les moyens de réception 22 recevant les moyens de fixation 21 sont formés par une cavité s'étendant longitudinalement entre la face avant 20a du module 20 et la face arrière 20b.

Les moyens de réception sont réalisés par exemple par alésage dans le module 20 d'une cavité cylindrique avec un diamètre suffisant pour laisser passer les moyens de fixation 21.

Dans un mode de réalisation, tel que celui représenté à la figure 2B, les moyens de fixation 21 traversent le module 20 entre la face avant 20a et la face arrière 20b de façon à permettre à un opérateur de fixer le module 20, depuis la face avant du module 20a, sur la face avant 31a de l'élément structural vertical 31.

Dans un mode de réalisation, les moyens de fixation 21 sont des vis d'une longueur prédéfinie, de sorte qu'elles traversent le module 20 entre ses faces avant 20a et arrière 20b.

Le diamètre de la cavité cylindrique formant des moyens de réception est ainsi de valeur suffisante pour laisser passer la tige de la vis.

Dans un autre mode de réalisation tel que celui représenté à la **figure 2C****,** les moyens de fixation 21' sont des vis d'une longueur inférieure à la profondeur du module 20.

Dans ce mode de réalisation, les moyens de réception 22' comportent une première portion cylindrique 22a' de diamètre suffisant pour recevoir la tête de la vis 21a' formant les moyens de fixation 21' et une seconde portion cylindrique 22b' de diamètre suffisant pour recevoir la tige de la vis 21b' et pour empêcher l'introduction de la tête de la vis 21a'.

Dans ce mode de réalisation un outil 2100 dédié à la fixation des vis 21' est nécessaire pour la fixation du module 20 aux éléments structuraux verticaux 31.

Dans le mode de réalisation représenté à la figure 2C, la vis a une empreinte hexagonale.

Bien entendu, des types de vis différentes peuvent être utilisées, avec des empreintes différentes, telle que triangulaire, Torx ou autre.

La structure porteuse 30 comporte des moyens de fixation complémentaires adaptés à recevoir les moyens de fixation 21 du module 20 et à coopérer avec eux pour la fixation du module 20 à la structure porteuse 30.

La face arrière du module 20b comporte, dans ce mode de réalisation, des zones renforcées 200 situées respectivement aux angles de la face arrière 20b où débouchent respectivement les moyens de réception 22, 22'. Ces zones renforcées 200 peuvent bien entendu s'appliquer au mode de réalisation décrit en référence à la figure 2B.

Le module 20 comporte en outre au moins un pion de centrage 210 (visible sur la figure 2C mais étant similaire dans les modes de réalisation représentés à la figure 2B).

Dans un mode de réalisation, un pion de centrage 210 est associé à chaque moyen de réception 22, 22' recevant les moyens de fixation 21, 21'.

Dans d'autres modes de réalisation, le module 20 comporte un nombre de pions de centrage 210 inférieur au nombre de moyens de fixation 21, 21'.

Les pions de centrage 210 permettent de positionner le module 20, lors de son montage, dans la position correcte de sorte que les moyens de fixation 21, 21' du module 20 coopèrent avec les moyens de fixation complémentaires des éléments structuraux verticaux 31.

Dans un mode de réalisation, un pion de centrage 210 comporte une excroissance s'étendant en saillie à partir de la face arrière du module 20b selon une direction perpendiculaire au plan dans lequel s'étend la face arrière du module 21b et dans une direction parallèle à la direction dans laquelle s'étendent les moyens de réception 22, 22'.

De manière non limitative, les pions de centrage 210 auraient pu être, par exemple, des douilles ou des goupilles de centrage ou tout autre élément aidant à guider les moyens de fixation 21, 21' dans la direction correcte pour la fixation sur l'élément structural vertical 31.

Chaque élément structural vertical 31 comporte des zones de fixation 310 adaptées à recevoir les moyens de fixation 21, 21' du module 20.

Ces zones de fixation 310 sont décrites en référence à la figure 2C mais s'appliquent aussi au mode de réalisation représentés sur la figure 2B.

Une zone de fixation 310 est prévue sur chaque élément structural vertical 31 pour chaque moyen de fixation 21, 21'.

Dans un mode de réalisation, la zone de fixation 310 comporte un premier perçage 310a conçu pour recevoir le pion de centrage 210 et un second perçage 310b conçu pour recevoir la tige de la vis 21b'.

Dans ce mode de réalisation, les moyens de fixation complémentaires comportent un écrou flottant (non visible) fixé au niveau du second perçage 310b.

Bien entendu, les moyens de fixation ainsi que les moyens de fixation complémentaires peuvent présenter d'autres modes de réalisation.

Ainsi, dans ces modes de réalisation, le module 20 peut être fixé sur les éléments structuraux verticaux 31 en introduisant les moyens de fixation 21, 21' dans les moyens de réception 22, 22', la fixation du module 20 sur la structure porteuse 30 pouvant être mise en œuvre de manière aisée par un opérateur depuis la face avant 20a du module 20.

On notera que la fixation du module 20 à la structure porteuse 30 peut être mise en œuvre une fois que la structure porteuse 30 est installée à un emplacement, sans nécessiter d'accéder à la partie arrière de la structure porteuse 30.

Bien entendu, d'autres modes de fixation 21, 21' peuvent être employés.

Comme il peut être visualisé aux figures 2A et 2C, dans les modes de réalisation décrits, chaque module 20 comporte quatre moyens de fixation 21, chaque moyen de fixation 21 étant disposé dans des moyens de réception 22 placés entre la face avant 20a et la face arrière 20b du module 20.

Bien entendu, le nombre de moyens de fixation et de moyens de réception peut être différent, bien que le nombre de quatre permette une fixation optimale du module 20 sur la structure porteuse 30.

Dans un mode de réalisation, le module 20 comporte en outre un caisson 23 situé sous les équipements électroniques 24.

Dans ce mode de réalisation, la fixation du module 20 sur l'élément vertical 31 est mise en œuvre en partie au niveau du caisson 23. En particulier, les moyens de fixation 21 situés sur la partie inférieure du module 20 traversent le caisson 23 de la face avant 20a du module 20 à la face arrière 20b du module 20.

L'ensemble 100 comporte un système de ventilation comportant des conduits de soufflage d'air et des conduits d'extraction d'air, afin d'évacuer la chaleur produite par les équipements électroniques 24.

Dans un mode de réalisation, chaque élément structural vertical 31 comporte un conduit de soufflage d'air 41 et un conduit d'extraction d'air 42 (visibles sur la figure 2B).

Un élément structural vertical 31, comportant à la fois un conduit de soufflage d'air 41 et un conduit d'extraction d'air 42, permet d'optimiser davantage l'espace occupé par la structure porteuse 30.

Le conduit de soufflage d'air 41 et le conduit d'extraction d'air 42 se trouvent à l'intérieur d'un élément structural vertical 31 et s'étendent longitudinalement à l'intérieur de l'élément structural vertical 31.

Dans un mode de réalisation, l'intérieur de l'élément structural vertical 31 est divisé de sorte à former le conduit de soufflage d'air 41 et le conduit d'extraction d'air 42.

Chaque module 20 comporte de la même manière un conduit de soufflage d'air 43 et un conduit d'extraction d'air 44.

Le système de ventilation est ainsi situé au plus proche des équipements électroniques 24, mettant ainsi en œuvre le refroidissement des équipements électroniques 24 de manière efficace sans ajouter des éléments à la structure porteuse 30.

On notera que l'ensemble des conduits de soufflage d'air 41, 43 et des conduits d'extraction d'air 42, 44 à l'intérieur des éléments structuraux verticaux 31 et des modules 20 forment le système de ventilation.

Les conduits d'extraction 43 et de soufflage d'air 44 du système de ventilation de l'ensemble comportent ainsi une partie positionnée dans les éléments verticaux 31 et une partie positionnée dans le module 20.

Les conduits de soufflage d'air 43 et d'extraction d'air 44 du module 20 sont situés à l'intérieur du caisson 23. Les conduits de soufflage d'air 43 et d'extraction d'air 44 du module 20 sont visibles sur la figure 2A.

Le caisson 23 permet, outre le passage de l'air du système de ventilation, d'aider au maintien en hauteur des équipements électroniques 24.

Dans un mode de réalisation, l'intérieur du caisson 23 est divisé en deux compartiments, chaque compartiment correspondant respectivement au conduit de soufflage d'air 43 et au conduit d'extraction d'air 44.

Par exemple, un élément d'isolation est placé entre les compartiments afin de les isoler thermiquement. L'élément d'isolation peut être une mousse isolante.

Dans un autre exemple, un volume d'air est emprisonné entre les compartiments pour éviter les échanges thermiques, tel que la conduction thermique entre eux, en particulier entre un compartiment contenant de l'air froid et un compartiment contenant de l'air chaud.

Dans le mode de réalisation décrit, le caisson 23 présente une forme d'hexaèdre et son intérieur est divisé en deux compartiments selon un plan diagonal 23a.

Dans le mode de réalisation représenté, le conduit de soufflage d'air 41 dans l'élément structural vertical 31 est situé au niveau de la face avant 31a de l'élément structural vertical 31. Autrement dit, le conduit de soufflage d'air 41 jouxte la face arrière 20b du module 20.

Le conduit de soufflage d'air 41 dans l'élément structural vertical 31, et le conduit de soufflage d'air 43 dans le module 20, sont reliés entre eux.

De la même façon, les conduits d'extraction d'air 42, 44 dans l'élément structural vertical 31 et dans le module 20 sont reliés entre eux.

Chaque élément structural vertical 31 comporte une sortie d'air 41a conçue pour être reliée au conduit de soufflage d'air 43 d'un module 20 et une entrée d'air 42a conçue pour être reliée au conduit d'extraction d'air 44 d'un module 20.

Les entrées d'air 42a et les sorties d'air 41a de l'élément structural vertical 31 sont situées au niveau de la partie inférieure du module 20.

Dans un mode de réalisation, un joint déformable cylindrique est positionné au niveau des portions de liaison entre les conduits de soufflage d'air 41, 43, de l'élément structural vertical 31 et du module 20 et entre les conduits d'extraction 42, 44 de l'élément structural vertical 31 et du module 20. Ces portions de liaison sont, selon un mode de réalisation, rigides. Le joint déformable assure l'étanchéité du système de ventilation.

Dans un autre mode de réalisation, les liaisons entre le conduit de soufflage d'air 43 et le conduit d'extraction d'air 44 du module 20 avec respectivement le conduit de soufflage d'air 41 et le conduit d'extraction d'air 42 de l'élément structural vertical 31, sont assurées par des joints souples déformables. Par exemple, le module 20 comporte deux raccordements de type manchon tronconique souple, un raccordement pour le conduit de soufflage d'air 43 et un raccordement pour le conduit d'extraction d'air 44. Les entrées d'air 42a et les sorties d'air 41a de l'élément structural vertical 31 sont de type manchon cylindrique souple. Lorsque le module 20 est fixé sur la structure porteuse 30, les raccordements dans le module 20 s'écrasent contre les raccordements complémentaires dans les éléments structuraux verticaux 31.

La déformation des raccordements permet de garantir l'étanchéité du système de ventilation. La déformation des raccordements ne nécessite pas de collier de serrage entre les raccordements respectifs.

Les entrées d'air 42a et sorties d'air 41a dans les éléments verticaux 31 peuvent être visualisées sur la **figure 3**. On notera que l'entrée d'air 42a et la sortie d'air 41a sont situées de part et d'autre de chaque élément structural vertical 31. Ainsi, un même module 20 est relié à l'entrée d'air 42a d'un premier élément structural vertical 311, et à la sortie d'air 41a d'un deuxième élément structural vertical 312.

Ainsi, le système de ventilation dans un élément structural vertical 31 est partagé entre deux modules 20 fixés côte à côte sur la structure porteuse 30.

Le fonctionnement du système de ventilation est représenté sur la figure 2A. De l'air froid provenant de l'extérieur de l'ensemble 100 est introduit dans le conduit de soufflage d'air 41 dans un premier élément structural vertical 31/311. L'air circulant à travers le conduit de soufflage d'air 41 sort du premier élément structural vertical 31/311 à travers les sorties d'air 41a vers les conduits de soufflage d'air 43 dans les modules 20.

On notera qu'afin de clarifier la figure 2A, seulement l'acheminement de l'air à travers un premier module 20 est représenté. Néanmoins, l'acheminement d'air est similaire pour les autres modules.

L'air circulant à travers le conduit de soufflage d'air 43 dans le premier module 20/201 traverse les équipements électroniques 24 du module 20/201. L'air emporte la chaleur dégagée par les équipements électroniques 24 vers le conduit d'extraction d'air 44 d'un deuxième module 20/202 situé au-dessus du premier module 20/201.

L'air dans le conduit d'extraction d'air 44 du deuxième module 20/202 est acheminé par l'entrée d'air 42a vers le conduit d'extraction d'air 42 d'un deuxième élément vertical 31/312, ce conduit d'extraction d'air 42 emmenant l'air chaud vers l'extérieur de la structure porteuse 30.

Le module 20 comporte en outre des éléments de renfort 26 (représentés sur les figures 2B et 1) situés sur les faces latérales 20c du module 20. On notera qu'une seule face latérale 20c est visible sur les figures.

Les éléments de renfort 26 renforcent le maintien du module 20 sur la structure porteuse 30, une fois le module 20 sur la structure porteuse 30 fixé. Autrement dit, les éléments de renfort 26 absorbent les efforts verticaux et de cisaillement du module 20.

Dans un mode de réalisation, les éléments de renfort 26 sont deux éléments longitudinaux, par exemple de forme rectangulaire ou tubulaire, s'étendant le long des faces latérales du module 20, dans un plan perpendiculaire au plan dans lequel se trouve la face avant 20a du module 20 et au plan dans lequel se trouve la face arrière 20b du module 20.

Dans ce mode de réalisation, les éléments de renfort 26 se croisent de sorte à former les diagonales des faces latérales 20c du module 20.

Dans un mode de réalisation, la structure porteuse 30 comporte deux éléments d'aide au montage 50 des modules 20 (voir figure 1).

Les éléments d'aide au montage 50 peuvent être des équerres fixées sur la face avant 31a des éléments structuraux verticaux 31. Deux équerres sont montées respectivement sur deux éléments structuraux verticaux 31 à la même hauteur de sorte à guider un module 20 lors de son montage.

On notera qu'un module 20 peut être posé sur deux équerres 50, les équerres 50 soutenant le module 20 pendant qu'un seul opérateur installe les moyens de fixation 21 de sorte à fixer le module 20 sur la structure porteuse 30.

L'opérateur peut faire coulisser le module 20 sur les équerres 50 pour que la face arrière 20b du module 20 entre en contact avec la face avant 31a de l'élément de support vertical 31. L'opérateur peut ensuite réaliser la fixation mécanique entre le module 20 et la structure porteuse 30. Cette fixation mécanique permet la connexion pneumatique et électronique du module 20 à la structure porteuse 30.

Grâce aux équerres 50, un seul opérateur est nécessaire pour la fixation des modules 20 sur la structure porteuse 30.

Les équerres 50 peuvent être démontées une fois que le module 20 est fixé sur la structure porteuse 30 de sorte à alléger l'ensemble 100.

## Revendications

1. Ensemble comportant un module (20) comportant des équipements électroniques (24), et une structure porteuse (30) associée, ladite structure porteuse (30) comportant au moins deux éléments structuraux verticaux (31) ayant une face avant (31a) et une face arrière (31b), ledit module (20) comportant des moyens de fixation (21 ; 21') conçus pour la fixation dudit module (20) sur la face avant (31a) desdits au moins deux éléments structuraux verticaux (31), **caractérisé en ce que** ladite structure porteuse comporte au moins une plaque (32) comportant une interface électrique conçue pour recevoir une interface électrique (29) dudit module (20), et **en ce que** les moyens de fixation sont logés par des moyens de réception (22) traversant le module (20) entre sa face avant (20a) et sa face arrière (20b).

2. Ensemble conforme à la revendication 1, **caractérisé en ce que** les moyens de réception recevant les moyens de fixation (21) sont formés par une cavité s'étendant longitudinalement entre la face avant (20a) et la face arrière (20b).

3. Ensemble selon la revendication 2, **caractérisé en ce que** lesdits moyens de fixation (21 ; 21') traversent ledit module (20) entre une face avant (20a) et une face arrière (20b) dudit module (20) et sont conçus pour être fixés sur la face avant (31a) des éléments structuraux verticaux (31).

4. Ensemble selon l'une des revendications 1 à 3, **caractérisé en ce que** ladite au moins une plaque (32) est placée entre lesdits au moins deux éléments structuraux verticaux (31) au niveau de ladite face avant (31a) desdits éléments structuraux verticaux (31), et ladite interface électrique comporte des liaisons électriques pour relier ladite interface électrique (32) de ladite structure porteuse (30) à un système de câblage électrique (60).

5. Ensemble selon l'une des revendications 1 à 4, **caractérisé en ce que** ledit ensemble comporte un système de ventilation comportant des conduits de soufflage d'air (41, 43) et des conduits d'extraction d'air (42, 44), un élément structural vertical (31) comportant un conduit de soufflage d'air (41) et un conduit d'extraction d'air (42).

6. Ensemble conforme à la revendication 5, **caractérisé en ce que** ledit module (20) comporte un conduit de soufflage d'air (43) et un conduit d'extraction d'air (44) dudit système de ventilation.

7. Ensemble selon la revendication 6, **caractérisé en ce que** ledit élément structural vertical (31) comporte une entrée d'air (42a) et une sortie d'air (41a), ledit conduit d'extraction d'air (44) dudit module (20) étant relié à ladite sortie (41a) d'air d'un premier élément structural vertical (311) et ledit conduit de soufflage d'air (43) dudit module (20) étant relié à ladite entrée d'air (42a) d'un second élément structural vertical (312).

8. Ensemble conforme à l'une des revendications 6 ou 7, **caractérisé en ce que** ledit module (20) comporte en outre un caisson (23) situé sous les équipements électroniques (25), lesdits conduits de soufflage d'air (43) et d'extraction d'air (44) étant situés à l'intérieur dudit caisson (23).

9. Ensemble conforme à la revendication 8, **caractérisé en ce que** desdits moyens de fixation (21 ; 21') traversent ledit caisson (23) entre lesdites faces avant (20a) et arrière (20b) dudit module (20).

10. Ensemble conforme à l'une des revendications 1 à 9 **caractérisé en ce que** ledit module (20) comporte des éléments de renfort situés sur des faces latérales (20c) dudit module (20).

11. Ensemble conforme à l'une des revendications 1 à 10, **caractérisé en ce que** ladite structure porteuse (30) comporte au moins deux éléments d'aide au montage (50) dudit module (20) sous la forme d'équerres, chaque élément d'aide au montage (50) étant fixé sur la face avant (31a) de chaque élément structural vertical (31).

12. Aéronef **caractérisé en ce qu'**il comporte au moins un ensemble conforme à l'une des revendications 1 à 11.

## Patentansprüche

1. Anordnung aufweisend ein Modul (20) mit elektronischen Ausrüstungen (24) und eine zugehörige Tragstruktur (30), die Tragstruktur (30) aufweisend mindestens zwei vertikale Strukturelemente (31) mit einer Vorderseite (31a) und einer Rückseite (31b), das Modul (20) aufweisend Befestigungsmittel (21; 21'), die zur Befestigung des Moduls (20) auf der Vorderseite (31a) der mindestens zwei vertikalen Strukturelemente (31) ausgelegt sind, **dadurch gekennzeichnet, dass** die Tragstruktur mindestens eine Platte (32) aufweist, die eine elektrische Schnittstelle aufweist, die ausgelegt ist, eine elektrische Schnittstelle (29) des Moduls (20) aufzunehmen, und dadurch, dass die Befestigungsmittel durch Aufnahmemittel (22) aufgenommen sind, die das Modul (20) zwischen dessen Vorderseite (20a) und dessen Rückseite (20b) durchqueren.

2. Anordnung nach Anspruch 1, **dadurch gekennzeichnet, dass** die Aufnahmemittel, die die Befestigungsmittel (21) aufnehmen, von einem Hohlraum gebildet sind, der sich längs zwischen der Vorderseite (20a) und der Rückseite (20b) erstreckt.

3. Anordnung nach Anspruch 2, **dadurch gekennzeichnet, dass** die Befestigungsmittel (21; 21') das Modul (20) zwischen einer Vorderseite (20a) und einer Rückseite (20b) des Moduls (20) durchqueren und ausgelegt sind, auf der Vorderseite (31a) der vertikalen Strukturelemente (31) befestigt zu sein.

4. Anordnung nach einem der Ansprüche 1 bis 3, **dadurch gekennzeichnet, dass** die mindestens eine Platte (32) zwischen den mindestens zwei vertikalen Strukturelementen (31) an der Vorderseite (31a) der vertikalen Strukturelemente (31) platziert ist und die elektrische Schnittstelle elektrische Verbindungen aufweist, um die elektrische Schnittstelle (32) der Tragstruktur (30) mit einem elektrischen Verkabelungssystem (60) zu verbinden.

5. Anordnung nach einem der Ansprüche 1 bis 4, **dadurch gekennzeichnet, dass** die Anordnung ein Ventilationssystem aufweist, das Lufteinblasleitungen (41, 43) und Luftabzugsleitungen (42, 44) aufweist, wobei ein vertikales Strukturelement (31) eine Lufteinblasleitung (41) und eine Luftabzugsleitung (42) aufweist.

6. Anordnung nach Anspruch 5, **dadurch gekennzeichnet, dass** das Modul (20) eine Lufteinblasleitung (43) und eine Luftabzugsleitung (44) des Ventilationssystems aufweist.

7. Anordnung nach Anspruch 6, **dadurch gekennzeichnet, dass** das vertikale Strukturelement (31) einen Lufteinlass (42a) und einen Luftauslass (41a) aufweist, wobei die Luftabzugsleitung (44) des Moduls (20) mit dem Luftauslass (41a) eines ersten vertikalen Strukturelements (311) und die Lufteinblasleitung (43) des Moduls (20) mit dem Lufteinlass (42a) eines zweiten vertikalen Strukturelements (312) verbunden ist.

8. Anordnung nach einem der Ansprüche 6 oder 7, **dadurch gekennzeichnet, dass** das Modul (20) ferner einen Kasten (23) aufweist, der sich unter den elektronischen Ausrüstungen (25) befindet, wobei sich die Lufteinblas-(43) und Luftabzugsleitungen (44) innerhalb des Kastens (23) befinden.

9. Anordnung nach Anspruch 8, **dadurch gekennzeichnet, dass** Befestigungsmittel (21; 21') den Kasten (23) zwischen der Vorderseite (20a) und der Rückseite (20b) des Moduls (20) durchqueren.

10. Anordnung nach einem der Ansprüche 1 bis 9, **dadurch gekennzeichnet, dass** das Modul (20) Verstärkungselemente umfasst, die sich auf den Seitenflächen (20c) des Moduls (20) befinden.

11. Anordnung nach einem der Ansprüche 1 bis 10, **dadurch gekennzeichnet, dass** die Tragstruktur (30) mindestens zwei winkelförmige Elemente zur Hilfe bei der Montage (50) des Moduls (20) aufweist, wobei jedes Montagehilfselement (50) auf der Vorderseite (31a) jedes vertikalen Strukturelements (31) befestigt ist.

12. Luftfahrzeug, **dadurch gekennzeichnet, dass** es mindestens eine Anordnung nach einem der Ansprüche 1 bis 11 umfasst.

## Claims

1. Assembly comprising a module (20) comprising electronic equipment items (24), and an associated supporting structure (30), said supporting structure (30) comprising at least two vertical structural elements (31) having a front face (31a) and a rear face (31b), said module (20) comprising fixing means (21; 21') designed to fix said module (20) onto the front face (31a) of said at least two vertical structural elements (31), **characterized in that** said supporting structure comprises at least one plate (32) comprising an electrical interface designed to receive an electrical interface (29) of said module (20), and **in that** the fixing means are housed by reception means (22) passing through the module (20) between its front face (20a) and its rear face (20b).

2. Assembly according to Claim 1, **characterized in that** the reception means receiving the fixing means (21) are formed by a cavity extending longitudinally between the front face (20a) and the rear face (20b).

3. Assembly according to Claim 2, **characterized in that** said fixing means (21; 21') pass through said module (20) between a front face (20a) and a rear face (20b) of said module (20) and are designed to be fixed onto the front face (31a) of the vertical structural elements (31).

4. Assembly according to one of Claims 1 to 3, **characterized in that** said at least one plate (32) is placed between said at least two vertical structural elements (31) at said front face (31a) of said vertical structural elements (31), and said electrical interface comprises electrical link means for linking said electrical interface (32) of said supporting structure (30) to an electrical wiring system (60).

5. Assembly according to one of Claims 1 to 4, **characterized in that** said assembly comprises a ventilation system comprising air blowing ducts (41, 43) and air extraction ducts (42, 44), a vertical structural element (31) comprising an air blowing duct (41) and an air extraction duct (42).

6. Assembly according to Claim 5, **characterized in that** said module (20) comprises an air blowing duct (43) and an air extraction duct (44) of said ventilation system.

7. Assembly according to Claim 6, **characterized in that** said vertical structural element (31) comprises an air inlet (42a) and an air outlet (41a), said air extraction duct (44) of said module (20) being linked to said air outlet (41a) of a first vertical structural element (311) and said air blowing duct (43) of said module (20) being linked to said air inlet (42a) of a second vertical structural element (312).

8. Assembly according to one of Claims 6 or 7, **characterized in that** said module (20) also comprises a box section (23) situated under the electronic equipment items (25), said air blowing (43) and air extraction (44) ducts being situated inside said box section (23).

9. Assembly according to Claim 8, **characterized in that** said fixing means (21; 21') pass through said box section (23) between said front (20a) and rear (20b) faces of said module (20).

10. Assembly according to one of Claims 1 to 9, **characterized in that** said module (20) comprises reinforcing elements situated on lateral faces (20c) of said module (20).

11. Assembly according to one of Claims 1 to 10, **characterized in that** said supporting structure (30) comprises at least two elements (50) for aiding in the mounting of said module (20) in the form of brackets, each mounting aid element (50) being fixed onto the front face (31a) of each vertical structural element (31).

12. Aircraft, **characterized in that** it comprises at least one assembly according to one of Claims 1 to 11.
